# EUROPÄISCHE PATENTSCHRIFT

(11) **EP 3 686 481 B1**
(45) Veröffentlichungstag und Bekanntmachung des Hinweises auf die Patenterteilung: **16.12.2020**
(21) Anmeldenummer: 20153324.7
(22) Anmeldetag: 23.01.2020
(51) Int. Cl.: F21S 8/06, F21V 29/83, F21V 29/76, F21W 131/40, F21W 131/407, F21Y 105/10, F21Y 115/10

(54) **KÜHLKÖRPER FÜR EINE LED-PLATINE**
HEAT SINK FOR A LED BOARD
DISSIPATEUR THERMIQUE POUR UNE PLATINE DEL

(30) Priorität: 24.01.2019 DE 202019100381 U
(43) Veröffentlichungstag der Anmeldung: 29.07.2020
(73) Patentinhaber: Zumtobel Lighting GmbH, 6850 Dornbirn (AT)
(72) Erfinder: Escourrou, Thibaut, 6850 Dornbirn (AT); Krajnjona, Dipl.-Ing. Michael, 6850 Dornbirn (AT); Pöhs, Mario, 6850 Dornbirn (AT); Schwaiger, Christoph, 6850 Dornbirn (AT)
(74) Vertreter: Thun, Clemens

(56) Entgegenhaltungen:
- US-A1- 2013 027 935
- US-A1- 2013 214 665
- US-A1- 2018 054 978

## Beschreibung

Die vorliegende Erfindung betrifft eine Anordnung bestehend aus einem Kühlkörper und einer zugehörigen LED-Platine sowie eine Leuchte mit einer entsprechenden Anordnung.

Der Einsatz von LEDs zu Beleuchtungszwecken führt zu dem Erfordernis, die während des Betriebs der LEDs auftretende Wärme effizient abzuführen. Auch wenn LEDs im Vergleich zu herkömmlichen Lichtquellen - wie z.B. Glühbirnen - eine verbesserte Effizienz aufweisen, besteht nach wie vor das Problem, dass während des Betriebs eine nicht unwesentliche Menge der zugeführten elektrischen Energie in Verlust-Wärme umgesetzt wird. Dieses Problem ist bei LEDs insbesondere relevant, da diese im Vergleich zu klassischen Lichtquellen sehr geringe Abmessungen aufweisen und dementsprechend konzentriert hohe Temperaturen auftreten können. Eine Beschädigung der LEDs sowie weiterer Komponenten, die für die Stromversorgung der LEDs verantwortlich sind, kann nur vermieden werden, wenn mit Hilfe geeigneter Maßnahmen eine zuverlässige Kühlung ermöglicht wird.

Überwiegend werden LEDs durch den Einsatz sogenannter Kühlkörper passiv gekühlt. Es handelt sich hierbei um Elemente aus einem gut leitfähigem Material, welche einerseits thermisch mit der LED beziehungsweise einer LED-Platine gekoppelt sind und andererseits derart ausgeführt sind, dass sie die Wärme weiterleiten und insbesondere an einem von den LEDs entfernten Ort an die Umgebung abgeben. Als geeignetes Material zur Realisierung derartiger Kühlkörper hat sich in der Vergangenheit insbesondere Aluminium erwiesen.

Um eine gute thermische Kopplung zwischen Kühlkörper und LED-Platine zu gewährleisten, sind Kühlkörper üblicherweise derart ausgebildet, dass sie eine plane geschlossene Auflagefläche für die LED-Platine bilden. Allenfalls Bohrungen, mit deren Hilfe ein Verschrauben der Platine mit dem Kühlkörper erfolgen kann, sind in der Auflagefläche vorgesehen, sodass möglichst großflächig ein thermischer Kontakt zwischen der Wärmequelle, also der LED-Platine, und dem Kühlkörper vorliegt. Das Abgeben der Wärme an die Umgebungsluft wird dann in der Regel dadurch gefördert, dass der Kühlkörper eine verhältnismäßig große Oberfläche aufweist, die in Kontakt mit der Umgebung ist. Um trotz allem die Abmessungen des Kühlkörpers in einem vertretbaren Rahmen zu halten, wird dessen Oberfläche üblicherweise dadurch vergrößert, dass diese eine Vielzahl rippenartiger Strukturen, sogenannter Kühlfinnen, aufweist. Zwischen den einzelnen Finnen bzw. Rippen kann dann idealerweise die Umgebungsluft strömen, um einerseits einen guten Wärmeaustausch zu erzielen, andererseits dann sofort abströmen zu können, um wiederum kühlere Luft in Kontakt mit dem Kühlkörper treten zu lassen. Eine derartige Kühlkörperstruktur mit einer geschlossenen, planen Auflagefläche für die LED-Platine ist beispielsweise aus der US 2018/0054978 A1 oder der US 2013/0027935 A1 bekannt.

Das oben beschriebene Konzept eines Kühlkörpers mit einer planen Auflagefläche für die Wärmequelle sowie Kühlrippen zum effizienten Wärmeaustausch mit der Umgebungsluft hat sich vielfach bewährt. Problematisch ist auf der anderen Seite, dass die durch die Kühlrippen vergrößerte Oberfläche dazu neigt, das Anlagern von Schmutz- und Staubpartikeln zu fördern. Insbesondere für den Fall des Einsatzes derartiger Kühlkörper in Industriebereichen, bei denen die Luft relativ staubhaltig sein kann, führt dies dazu, dass die Oberfläche des Kühlkörpers verhältnismäßig schnell mit Staub behaftet ist. Die Kühlrippen fördern dabei nicht nur das Anlagern von Staub, sondern erschweren darüber hinaus auch eine Reinigung des Kühlkörpers, da oftmals zwischen den einzelnen Rippen nur schmale Spalte oder Freiräume verbleiben.

Ein anderes Konzept zur Realisierung eines Kühlkörpers ist in der US 2013/0214665 A1 beschrieben. Hier weist ein Kühlkörper für eine LED-Lichtquelle, mit der ein Ersatz für klassische Glühlampen geschaffen werden soll, ein im Wesentlichen geschlossenes, etwa halbkugelförmiges Gehäuse auf. Ausgehend von dem äußeren Gehäuse erstrecken sich intern in dem Kühlkörper Rippen zum Zentrum hin, wobei auf den Oberseiten der Rippen eine Metallplatte zur Wärmekopplung angeordnet ist, auf der wiederum eine LED-Platine angeordnet ist.

Der vorliegenden Erfindung liegt die Aufgabenstellung zu Grunde, eine Möglichkeit zur effizienten Kühlung einer LED-Lichtquelle zur Verfügung zu stellen, bei der die oben genannten Probleme vermieden werden.

Die Aufgabe wird durch eine Anordnung aufweisend einen Kühlkörper sowie eine LED-Platine mit den Merkmalen des Anspruchs 1 gelöst. Vorteilhafte Weiterbildungen der Erfindung sind Gegenstand der abhängigen Ansprüche.

Die erfindungsgemäße Lösung beruht auf dem Gedanken, einen Kühlkörper für eine LED-Platine derart zu gestalten, dass er möglichst glatte Außenflächen aufweist, welche weniger stark das Anlagern von Schmutz- oder Staubpartikeln fördern und darüber hinaus auch deutlich einfacher zu reinigen sind. Der Wärmeaustausch mit der Umgebung erfolgt bei dem erfindungsgemäßen Kühlkörper also nicht durch eine Vielzahl einzelner Kühlrippen, sondern stattdessen über eine möglichst glatte Außenfläche. Auch der erfindungsgemäße Kühlkörper weist rippenartige Strukturen auf. Diese sind nun allerdings nicht unmittelbar für den Wärmeaustausch mit der Umgebung verantwortlich, sondern dienen in erster Linie der thermischen Kopplung mit der LED-Platine. Sie erstrecken sich einstückig ausgehend von dem Außenmantel des Kühlkörpers derart, dass dem Außenmantel gegenüberliegende Abschlusskanten der Rippen in einer gemeinsamen Ebene verlaufen, so dass sie eine im Wesentlichen plane Auflage bilden, auf der unmittelbar aufliegend eine LED-Platine angeordnet ist.

Erfindungsgemäß wird also eine Anordnung bestehend aus einem Kühlkörper sowie einer LED-Platine vorgeschlagen, wobei der Kühlkörper einen Außenmantel aufweist, der zumindest einen im Wesentlichen geschlossenen Oberflächenbereich aufweist, von dem aus sich einstückig mit dem Außenmantel verbundene Rippen erstrecken, wobei dem geschlossenen Oberflächenbereich gegenüberliegende Abschlusskanten der Rippen derart in einer gemeinsamen Ebene verlaufen, dass sie eine im Wesentlichen plane Auflage, und wobei die LED-Platine auf den Abschlusskanten der Rippen aufliegend angeordnet ist.

Mit der vorliegenden Erfindung wird sozusagen ein klassischer Kühlkörper invertiert. Die üblicherweise im Wesentlichen geschlossene Auflagefläche, die normalerweise der Lagerung und thermischen Kopplung mit der Wärmequelle dient, wird nunmehr zum Wärmeaustausch mit der Umgebung verwendet, während hingegen die Kühlrippen für die Übertragung der Wärme von der LED-Platine zum Außenmantel des Kühlkörpers verantwortlich sind und derart ausgeführt sind, dass sie eine plane Auflage für die LED-Platine bilden. Der geschlossene Oberflächenbereich des Außenmantels muss dabei nicht zwingend plan ausgeführt sein, sondern kann auch anderweitig geformt, beispielsweise gekrümmt sein. Die Gestaltung dieser Außenfläche kann dabei insbesondere dahingehend optimiert sein, dass ein Vorbeiströmen der Luft gefördert wird. Beispielsweise hat sich eine giebelartige Konstruktion mit gekrümmten Außenflächen als vorteilhaft herausgestellt. Somit wird trotz allem eine effiziente Kühlung der LED-Lichtquelle ermöglicht, gleichzeitig jedoch werden die oben geschilderten Probleme klassischer Kühlkörper vermeiden.

Vorzugsweise sind die Rippen des Kühlkörpers parallel zueinander ausgerichtet. Ferner ist in besonders bevorzugter Weise vorgesehen, dass der Außenmantel des Kühlkörpers vollständig geschlossen ist. Der geschlossene Oberflächenbereich des Kühlkörpers kann dabei wie bereits erwähnt gekrümmt ausgebildet sein, da in diesem Fall ein besonders effizientes Vorbeiströmen der zur Kühlung genutzten Luft realisiert werden kann.

Vorzugsweise ist vorgesehen, dass die LED-Platine mehrere LEDs aufweist, wobei sämtliche LEDs jeweils oberhalb der Abschlusskanten der Rippen des Kühlkörpers positioniert sind. Die räumliche Nähe der LEDs zu den Rippen führt dazu, dass in besonders effizienter Weise die Wärme auf den Kühlkörper übertragen und durch die Rippen weitergeleitet werden kann. Vorzugsweise sind hierbei die LEDs im Wesentlichen gleichmäßig verteilt auf der Platine angeordnet. Letztendlich ergibt sich idealerweise eine Konfiguration, bei der der Außenmantel des Kühlkörpers und die LED-Platine gemeinsam einen Kühlkörperinnenraum im Wesentlichen vollständig umschließen, wobei sich durch den Innenraum dann die Rippen erstrecken.

Schließlich wird erfindungsgemäß eine Leuchte vorgeschlagen, welche eine Anordnung bestehend aus einem Kühlkörper und einer LED-Platine gemäß der vorliegenden Erfindung aufweist.

Nachfolgend soll die Erfindung an Hand der beiliegenden Zeichnung näher erläutert werden. Es zeigen:
- Figuren 1 und 2: Ansichten einer Leuchte, bei der erfindungsgemäße Anordnungen bestehend aus einem Kühlkörper und LED-Platinen zum Einsatz kommen;
- Figur 3: eine weitere Ansicht der Leuchte der Figuren 1 und 2, wobei der Innenraum der Kühlkörper erkennbar ist;
- Figur 4: einer perspektivische Schnittdarstellung der Leuchte der Figuren 1 und 2;
- Figur 5: eine Schnittdarstellung des Kühlkörpers ohne darauf angeordneter LED-Platine und
- Figur 6: eine Schnittdarstellung des Kühlkörpers mit einer darauf angeordneten LED-Platine.

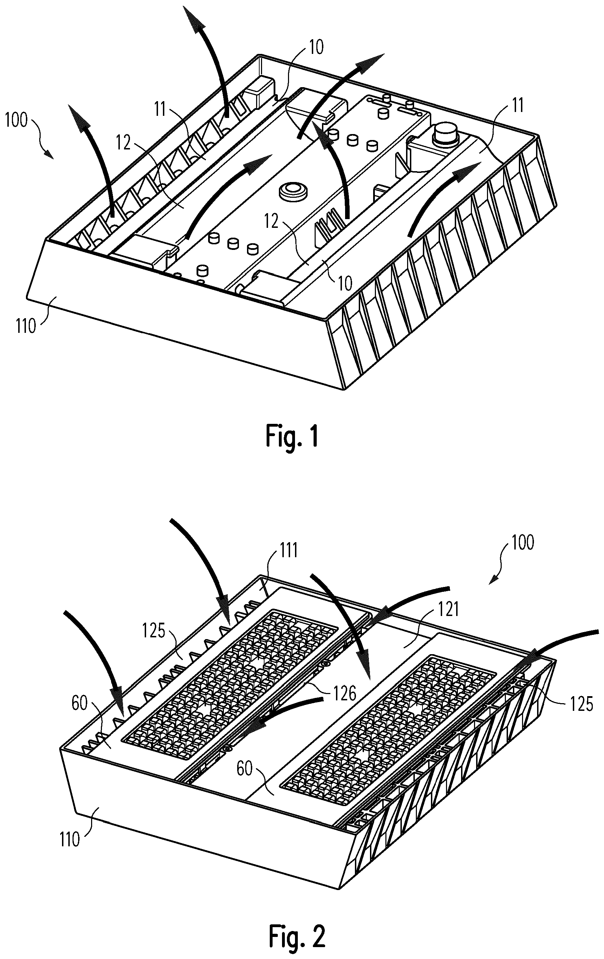

Das in den Figuren 1 und 2 dargestellte Ausführungsbeispiel einer Leuchte 100 mit erfindungsgemäßen Kühlkörpern geht von einer Leuchte aus, wie sie beispielsweise in der WO 2014/086770 A1 der Anmelderin beschrieben ist. Es handelt sich um eine sogenannte High Bay-Leuchte, also eine Leuchte, die beispielsweise zur Beleuchtung von größeren Hallen oder Industriekomplexen verwendet wird. Da hier die Leuchte 100 üblicherweise in einem verhältnismäßig großen Abstand zum Boden montiert ist, soll Licht mit hoher Intensität erzeugt werden, welches dann auf den darunterliegenden Bereich der Halle gestrahlt wird. Dementsprechend kommen hier leistungsstarke Leuchtmittel zum Einsatz, die in geeigneter Weise gekühlt werden müssen. Allerdings ist das erfindungsgemäße Konzept der speziellen Ausgestaltung des Kühlkörpers nicht auf die dargestellte Leuchte beschränkt, sondern kann vielfach auch bei anderen Leuchtentypen Verwendung finden.

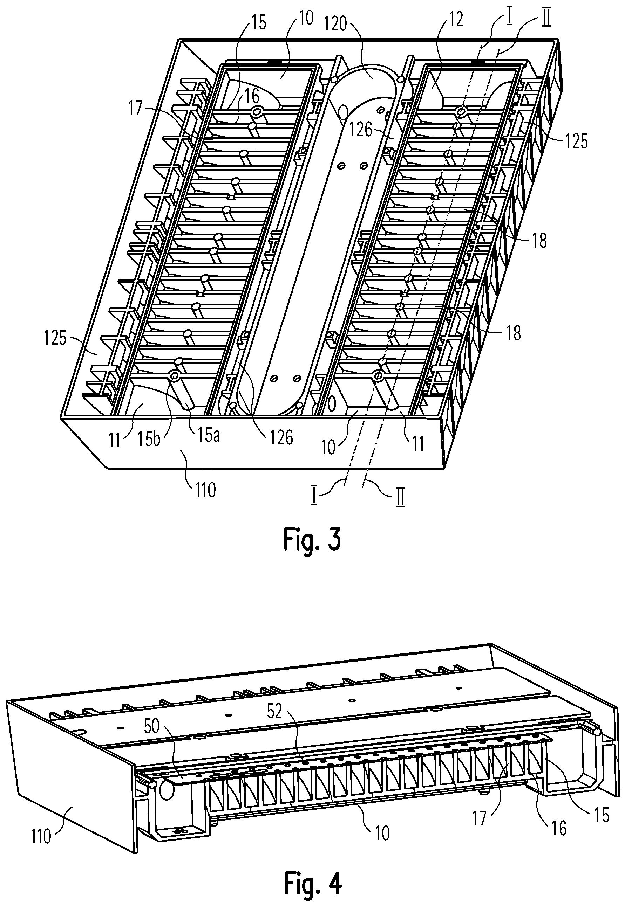

Die in den Figuren 1 und 2 dargestellte Leuchte 100 weist also ein Gehäuse 110 mit einer im vertikalen Schnitt etwa trapezartigen Konfiguration auf, mit einer zur Unterseite hin erweiterten rechteckigen bzw. quadratischen Öffnung 111. Innerhalb des Gehäuses 110 ist herbei mittig ein Bereich 120 ausgebildet, der zur Lagerung elektronischer Komponenten zur Stromversorgung der Leuchtmittel dient. Insbesondere können in diesem zentralen Bereich 120 beispielsweise ein oder mehrere Betriebsgeräte gelagert werden, welche die der Leuchte 100 zugeführte Versorgungsspannung in eine geeignete Betriebsspannung für die LED-Leuchtmittel umsetzen. Dieser zentrale Bereich, der auch in Figur 4 erkennbar ist, ist im Betrieb durch eine Abdeckplatte 121 zur Unterseite hin verschlossen.

Die Leuchtmittel selbst sind parallel zu beiden Seiten des zentralen Bereichs 120 angeordnet und insbesondere in der Ansicht gemäß Figur 2 sowie den Figuren 4 und 6 erkennbar. Insbesondere kommen zwei LED-Platinen 50 zum Einsatz, welche eine Vielzahl matrixartig angeordneter LEDs 52 aufweisen. Üblicherweise sind die LEDs 52 hier im Wesentlichen gleichmäßig verteilt angeordnet, wobei jedoch gegebenenfalls an bestimmten Positionen einzelne LEDs 52 fehlen können, um beispielsweise ein Verschrauben der Platine 50 mit dem nachfolgend noch näher beschriebenen Kühlkörper zu ermöglichen.

Den LED-Platinen vorgeordnet ist jeweils eine zumindest teilweise lichtdurchlässige Abdeckung 60, welche die zugehörige Platine 50 vollständig überdeckt und somit vor äußeren Einflüssen schützt. Diese Abdeckung 60 kann integriert optische Elemente, beispielsweise Linsen, aufweisen, mit deren Hilfe das von den LEDs emittierte Licht in geeigneter Weise beeinflusst wird. Dabei ist idealerweise jeder LED 52 jeweils eine einzelne Linse zugeordnet.

Eine besondere Eigenschaft der in der oben genannten internationalen Anmeldung beschriebenen Leuchte, die auch bei der in den Figuren 1 und 2 dargestellten erfindungsgemäßen Leuchte 100 zum Einsatz kommt, besteht darin, dass die Unterseite des Leuchtengehäuses 110 nicht vollständig durch die Abdeckung 121 des zentralen Bereichs 120 sowie die beiden Abdeckungen 60 für die Leuchtmittel geschlossen ist. Stattdessen sind zu beiden Seiten der LED-Leuchtmittel jeweils Durchgangsöffnungen 125, 126 oder Freiräume vorgesehen, die das Durchströmen von Luft von der Unterseite der Leuchte 100 her zur Oberseite hin ermöglichen. Dieses Konzept, welches in der oben erwähnten Schrift ausführlich erläutert wird, sieht also vor, dass die unterhalb der Leuchte 100 befindliche Luft, welche eine niedrigere Temperatur aufweist, entsprechend den dargestellten Pfeilen in den Figuren 1 und 2 zu beiden Seiten der Leuchtmittel jeweils durch das Leuchtengehäuse 110 strömt und an der Oberseite wieder austritt, wodurch eine effiziente Kühlung der LED-Leuchtmittel erzielt wird. Während des Betriebs der Leuchte 100 wird hierdurch ein Kamineffekt generiert, der dafür sorgt, dass die LED-Leuchtmittel kontinuierlich von Kühlluft umströmt werden, sodass trotz der hohen Leistung der Leuchtmittel und damit der starken Wärmeentwicklung keine Überhitzung der elektronischen Komponenten zu befürchten ist.

Wie der Darstellung der Figuren 1 und 2 entnehmbar ist, ist die Außenseite des Gehäuses 110 an beiden Längsseiten 115 mit leicht rippenartigen Strukturen 116 versehen. Diese Seitenwände 115 sind allerdings wie bereits erwähnt durch die Durchströmöffnungen 125, 126 für die Luft von den LED-Leuchtmitteln getrennt und tragen dementsprechend nur zu einem geringen Grad zur Kühlung der LED-Leuchtmittel bei. Die eigentliche Kühlung muss durch denjenigen Bereich des Leuchtengehäuses 110 erfolgen, der unmittelbar in thermischem Kontakt mit den LED-Platinen 50 ist. Es handelt sich hierbei jeweils um einen in der nachfolgend beschriebenen erfindungsgemäßen Weise ausgestalteten Kühlkörper.

Bei der Leuchte gemäß dem Stand der Technik war der Kühlkörper derart ausgestaltet, dass er eine plane Auflagefläche für die zugehörige LED-Platine bildete. An der Oberseite hingegen wies dieser Kühlkörper die bereits eingangs geschilderten sich vertikal erstreckenden Kühlrippen auf, welche auf Grund ihrer großen Oberfläche eine geeignete Übertragung der Wärme an die Umgebungsluft ermöglichten.

Bei der erfindungsgemäßen Leuchte 100 ist nunmehr vorgesehen, dass auf die nach oben bzw. außen gerichteten Rippen verzichtet wird. Stattdessen sind die mit dem Bezugszeichen 10 versehenen Kühlkörper derart ausgeführt, dass sie möglichst glatte und geschlossene Oberflächenbereiche aufweisen. Im dargestellten Ausführungsbeispiel ist insbesondere vorgesehen, dass die Außenfläche eines Kühlkörpers 10 im Wesentlichen durch zwei sich giebelartig zur Oberseite hin erstreckende Wände 11 und 12 gebildet wird, die vorzugsweise keine Öffnungen, insbesondere jedoch keine rippenartigen Erweiterungen zur Vergrößerung ihrer Oberfläche aufweisen. Stattdessen sind die Wände 11, 12 wie bereits erwähnt möglichst glatt ausgeführt, sodass das Anlagern von Staub- oder Schmutzpartikeln vermieden wird. Gleichzeitig können sie allerdings - wie Figur 1 entnommen werden kann - eine gewisse konkave Krümmung aufweisen. Diese Krümmung sowie die entsprechende Neigung der Oberflächen 11, 12 kann dabei derart gewählt werden, dass die durch die Öffnungen strömende Luft 125, 126 möglichst effizient an den Außenflächen 11, 12 des Kühlkörpers 10 entlang strömt und dementsprechend Wärme effizient abgeführt wird. Im Vergleich zu rippenartigen Erweiterungen kann mit Hilfe der glatten Außenflächen 11, 12 sogar eine deutlich bessere Luftströmung erzielt werden, sodass trotz der im Vergleich zu klassischen Kühlkörpern reduzierten Oberfläche eine vergleichbare Ableitung der Wärme an die Umgebungsluft realisiert werden kann.

Die Ableitung der während des Betriebs durch die LED-Leuchtmittel generierten Wärme ist allerdings nur dann möglich, wenn eine gute thermische Kopplung zwischen dem Kühlkörper 10 und den LED-Leuchtmitteln vorliegt. Idealerweise sollte deshalb der Kühlkörper 10 möglichst massiv gestaltet sein, da dies die größtmögliche Wärmeübertragung gewährleistet. Da eine entsprechend massive Ausgestaltung allerdings auf Grund des damit verbundenen Materialaufwands sowie der Herstellungskosten nicht gerechtfertigt ist, ist gemäß der vorliegenden Erfindung bei dem Kühlkörper 10 eine spezielle Lagerung der LED-Leuchtmittel vorgesehen, die nachfolgend an Hand der weiteren Figuren 3 bis 6 näher erläutert werden soll.

Figur 3 zeigt hierzu eine weitere Ansicht der Unterseite des Leuchtengehäuses 110, wobei nunmehr allerdings auf die Darstellung der Abdeckungen 60, 121 sowie der LED-Leuchtmittel verzichtet wurde, derart, dass nunmehr der Innenraum der Kühlkörper 10 erkennbar ist.

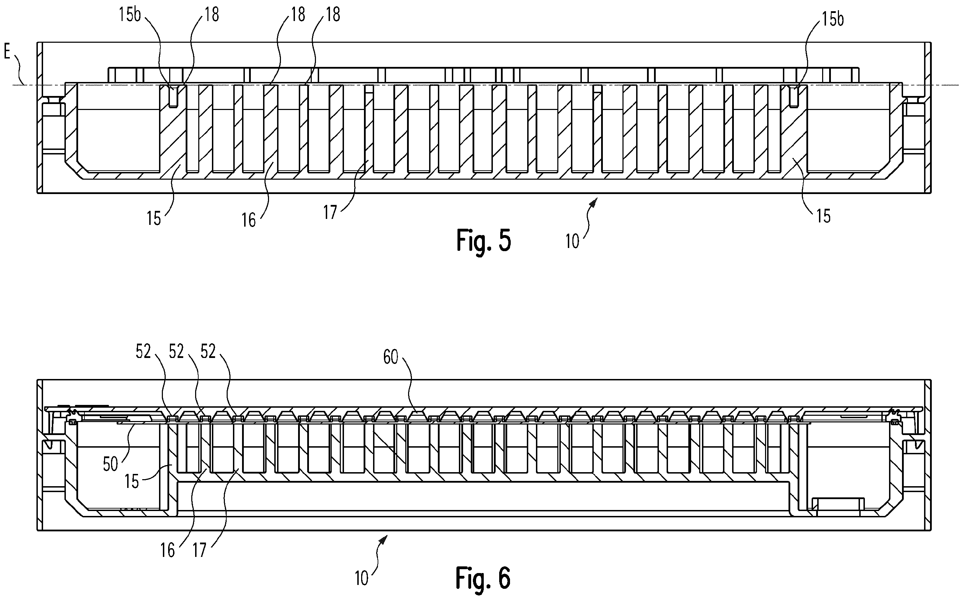

Figur 3 sowie die weiteren Figuren 4 bis 6 zeigen dementsprechend, dass der Kühlkörper 10 wiederum rippenartige Strukturen 15 bis 17 aufweist, die nunmehr allerdings nicht zur Außenseite hin gerichtet sind, sondern sich - idealerweise einstückig - ausgehend von den Außenflächen 11 und 12 in den von diesen Außenflächen 11, 12 umschlossenen Innenraum erstrecken. Genau genommen sind die Rippen 15 bis 17 derart ausgeführt, dass sie den Innenraum durchsetzen und Abschlusskanten 18 aufweisen, welche alle in einer gemeinsamen Ebene E - siehe Figur 5 - liegen. Damit bilden die Abschlusskanten 18 der Rippen 15 bis 17 eine im Wesentlichen plane Auflage für eine LED-Platine und können dann dazu verwendet werden, die während des Betriebs der LEDs auftretende Wärme an die Außenflächen 11, 12 des Kühlkörpers 10 weiterzuleiten.

Wie die Figuren 3 bis 6 zeigen, weisen die beiden Kühlkörper 10 jeweils eine Vielzahl von parallel ausgerichteten Rippen 15 bis 17 auf. Im dargestellten Ausführungsbeispiel sind drei verschiedene Arten von Rippen vorgesehen.

Der erste Typ kommt dabei jeweils bei der ersten und letzten Rippe 15 zum Einsatz und ist mit einer zentralen Erweiterung 15a mit einer Bohrung 15b versehen. Diese beiden Rippen 15 sind für die Befestigung der LED-Platine 50 verantwortlich und ermöglichen insbesondere ein Verschrauben der Platine 50 mit dem Kühlkörper 10.

Zwischen den beiden End-Rippen 15 sind dann beispielsweise alternierend die Rippen 16 und 17 des zweiten und dritten Typs angeordnet. Diese unterscheiden sich lediglich darin, dass bei den Rippen des zweiten Typs 16 zentrale Versteifungen vorgesehen sind, während hingegen die Rippen des dritten Typs 17 über ihre gesamte Breite hinweg einen unveränderten Querschnitt aufweisen. Diese Veränderung des Durchmessers im zentralen Bereich der Rippen 16 ist auch in der Schnittdarstellung gemäß Figur 5 erkennbar, wobei hier ein Schnitt entlang der Gerade I-I von Figur 3 gezeigt ist.

Anzumerken ist, dass die Nutzung der oben beschriebenen drei unterschiedlichen Rippen-Typen 15 bis 17 nicht zwingend erforderlich ist und die Rippen auch anderweitig gestaltet sein können. Wesentlich ist allerdings, dass sie alle unabhängig von der Form der Außenflächen des Kühlkörpers 10 in einer gemeinsamen Ebene E enden und dementsprechend eine plane Auflagemöglichkeit für die LED-Platine bilden. Die Außenkontur des Kühlkörpers 10 kann also im Wesentlichen frei gewählt werden und insbesondere optimiert werden, um eine effiziente Luftströmung zu erzielen, da dies durch die Rippen 15 bis 17 in geeigneter Weise ausgeglichen werden kann, derart, dass trotz allem eine plane Auflage für die LED-Platine 50 erzielt wird. Die Rippen 15 bis 17 müssen dabei auch nicht wie dargestellt zwangsläufig parallel zueinander ausgerichtet sein, sondern können auch gegebenenfalls diagonal oder in Form eines Rasters verlaufen.

Die erfindungsgemäße Anordnung einer LED-Platine 50 auf dem Kühlkörper 10 ist in den Figuren 4 und 6 gezeigt, wobei Figur 6 wiederum einen Schnitt, nunmehr entlang der Geraden II-II von Figur 3 zeigt. Erkennbar ist hierbei, dass die Platine 50 tatsächlich auf den Ober- beziehungsweise Abschlusskanten der Rippen 15 bis 17 aufliegt. Dabei ist entsprechend der Darstellung gemäß den Figuren 4 und 6 idealerweise vorgesehen, dass die Anordnung der Rippen auf die Anordnung der LEDs 52 auf der Platine 50 abgestimmt ist. Insbesondere ist idealerweise vorgesehen, dass die LEDs 52 immer genau oberhalb der Kante einer zugehörigen Rippe 15 bis 17 ruhen, sodass die während des Betriebs entstehende Wärme unmittelbar an die unterhalb der LED 52 verlaufende Rippe 15, 16 oder 17 abgegeben werden kann. In diesem Fall ist eine besonders gute Übertragung der Wärme auf den Kühlkörper 10 gewährleistet.

Letztendlich umschließen also idealerweise die Außenwände 11 und 12 des Kühlkörpers 10 gemeinsam mit der LED-Platine 50 einen Innenraum des Kühlkörpers 10, durch den sich die zur Lagerung der Platine 50 genutzten Rippen 15-17 erstrecken. Der Innenraum selbst weist also zahlreiche Hohlräume auf, wie dies in der Schnittdarstellung der Figuren 4 bis 6 erkennbar ist. Zur Außenseite hin wird hingegen ein im Wesentlichen geschlossenes System mit möglichst glatten Oberflächen gebildet. Wie bereits erwähnt, wird trotz allem eine gute Ableitung der Wärme erzielt, da einerseits die dargestellte Konfiguration eine gute Übertragung der Wärme auf den Kühlkörper ermöglicht, andererseits die Außenflächen 11 und 12 eine optimierte Strömung der Umgebungsluft ermöglichen.

Anzumerken ist hierbei, dass der Kühlkörper 10 im dargestellten Ausführungsbeispiel integraler Bestandteil des Leuchtengehäuses 110 ist, welches in diesem Fall dann vorzugsweise als einstückiges Bauteil ausgeführt ist. Selbstverständlich kann das erfindungsgemäße Konzept allerdings auch bei separat ausgebildeten Kühlkörpern realisiert werden.

Insgesamt wird durch die vorliegende Erfindung also eine Anordnung bestehend aus einem Kühlkörper und einer LED-Platine zur Verfügung gestellt, bei dem die eingangs geschilderten Probleme im Vergleich zur klassischer Ausgestaltung von Kühlkörpern vermieden werden, andererseits jedoch trotz allem eine effiziente und gute Ableitung der während des Betriebs auftretenden Wärme ermöglicht wird.

## Patentansprüche

1. Anordnung bestehend aus einem Kühlkörper (10) sowie einer LED-Platine (50), wobei der Kühlkörper (10) einen Außenmantel aufweist, der zumindest einen geschlossenen Oberflächenbereich (11, 12) aufweist, von dem sich aus einstückig mit dem Außenmantel verbundene Rippen (15, 16, 17) erstrecken,
wobei dem geschlossenen Oberflächenbereich (11, 12) gegenüberliegende Abschlusskanten (18) der Rippen (15, 16, 17) derart in einer gemeinsamen Ebene (E) verlaufen, dass sie eine im Wesentlichen plane Auflage bilden,
**dadurch gekennzeichnet,**
**dass** die LED-Platine (50) auf den Abschlusskanten (18) der Rippen (15, 16, 17) des Kühlkörpers (10) aufliegend angeordnet ist.

2. Anordnung nach Anspruch 1,
**dadurch gekennzeichnet,**
**dass** die Rippen (15, 16, 17) parallel zueinander ausgerichtet sind.

3. Anordnung nach Anspruch 1 oder 2,
**dadurch gekennzeichnet,**
**dass** zumindest einige der Rippen (15, 16, 17) Bohrungen (15b) aufweisen, über die ein Verschrauben mit der LED-Platine (50) ermöglicht wird.

4. Anordnung nach einem der vorherigen Ansprüche,
**dadurch gekennzeichnet,**
**dass** der Außenmantel des Kühlkörpers (10) vollständig geschlossen ist.

5. Anordnung gemäß einem der vorherigen Ansprüche,
**dadurch gekennzeichnet,**
**dass** der geschlossene Oberflächenbereich (11, 12) gekrümmt ausgebildet ist.

6. Anordnung nach einem der vorherigen Ansprüche,
**dadurch gekennzeichnet,**
**dass** der Außenmantel des Kühlkörpers (10) durch zwei giebelartig aufeinander zu laufende Außenflächen gebildet ist, welche vorzugsweise eine Krümmung aufweisen.

7. Anordnung nach einem der vorherigen Ansprüche,
**dadurch gekennzeichnet,**
**dass** die LED-Platine (50) mehrere LEDs (52) aufweist, wobei sämtliche LEDs (52) jeweils oberhalb der Abschlusskante (18) einer Rippe (15, 16, 17) des Kühlkörpers (10) positioniert sind.

8. Anordnung nach einem der vorherigen Ansprüche,
**dadurch gekennzeichnet,**
**dass** die LEDs (52) im Wesentlichen gleichmäßig verteilt auf der LED-Platine (50) angeordnet sind.

9. Anordnung nach einem der vorherigen Ansprüche,
**dadurch gekennzeichnet,**
**dass** der Außenmantel des Kühlkörpers (10) und die LED-Platine (50) gemeinsam einen Kühlkörperinnenraum umschließen, durch den sich die Rippen (15, 16, 17) erstrecken.

10. Leuchte (100), aufweisend zumindest eine Anordnung bestehend aus einem Kühlkörper (10) und einer LED-Platine (50) gemäß einem der vorherigen Ansprüche.

11. Leuchte nach Anspruch 10,
**dadurch gekennzeichnet,**
**dass** die Leuchte (100) an zumindest einer Seite der Anordnung bestehend aus dem Kühlkörper (10) und der LED-Platine (50) Luftdurchströmöffnungen (125, 126) aufweist.

12. Leuchte nach Anspruch 11,
**dadurch gekennzeichnet,**
**dass** zu beiden Seiten der Anordnung bestehend aus dem Kühlkörper (10) und der LED-Platine (50) Luftdurchströmöffnungen (125, 126) ausgebildet sind.

13. Leuchte nach einem der Ansprüche 10 bis 12,
**dadurch gekennzeichnet,**
**dass** der Kühlkörper (10) einstückiger Bestandteil eines Gehäuseteils ist.

## Claims

1. Arrangement consisting of a heat sink (10) and an LED board (50), wherein the heat sink (10) has an outer casing which has at least one closed surface region (11, 12) from which there extend ribs (15, 16, 17) integrally connected to the outer casing,
wherein terminating edges (18) of the ribs (15, 16, 17) opposite the closed surface region (11, 12) run in a common plane (E) in such a way that they form a substantially planar support,
**characterized in that**
the LED board (50) is arranged resting on the terminating edges (18) of the ribs (15, 16, 17) of the heat sink (10).

2. Arrangement according to Claim 1,
**characterized in that**
the ribs (15, 16, 17) are aligned parallel to each other.

3. Arrangement according to Claims 1 or 2,
**characterized in that**
at least some of the ribs (15, 16, 17) have holes (15b) by means of which a screw connection to the LED board (50) is made possible.

4. Arrangement according to any one of the preceding claims,
**characterized in that**
the outer casing of the heat sink (10) is completely closed.

5. Arrangement according to any one of the preceding claims,
**characterized in that**
the closed surface region (11, 12) is curved.

6. Arrangement according to any one of the preceding claims,
**characterized in that**
the outer casing of the heat sink (10) is formed by two outer surfaces which run toward each other in the manner of a gable and which preferably have a curvature.

7. Arrangement according to any one of the preceding claims,
**characterized in that**
the LED board (50) has a plurality of LEDs (52), wherein all LEDs (52) are in each case positioned above the terminating edge (18) of a rib (15, 16, 17) of the heat sink (10).

8. Arrangement according to any one of the preceding claims,
**characterized in that**
the LEDs (52) are arranged distributed substantially uniformly on the LED board (50).

9. Arrangement according to any one of the preceding claims,
**characterized in that**
the outer casing of the heat sink (10) and the LED board (50) jointly enclose an internal heat sink space through which the ribs (15, 16, 17) extend.

10. Luminaire (100), comprising at least one arrangement consisting of a heat sink (10) and an LED board (50), according to any one of the preceding claims.

11. Luminaire according to Claim 10,
**characterized in that**
the luminaire (100) has air throughflow openings (125, 126) on at least one side of the arrangement consisting of the heat sink (10) and the LED board (50).

12. Luminaire according to Claim 11,
**characterized in that**
air throughflow openings (125, 126) are formed on both sides of the arrangement consisting of the heat sink (10) and the LED board (50).

13. Luminaire according to any one of Claims 10 to 12,
**characterized in that**
the heat sink (10) is an integral component of a housing part.

## Revendications

1. Agencement constitué par un corps de refroidissement (10) ainsi que par une platine LED (50), le corps de refroidissement (10) présentant une enveloppe externe qui présente au moins une zone surfacique fermée (11, 12), dont s'étendent des ailettes (15, 16, 17) reliées d'une seule pièce à l'enveloppe externe,
les bords de fermeture (18) des ailettes (15, 16, 17), opposées à la zone surfacique fermée (11, 12), s'étendant dans un plan commun (E) de manière telle qu'ils forment un support sensiblement plan,
**caractérisé en ce que**
la platine LED (50) est agencée en étant posée sur les bords de fermeture (18) des ailettes (15, 16, 17) du corps de refroidissement (10).

2. Agencement selon la revendication 1,
**caractérisé en ce que**
les ailettes (15, 16, 17) sont orientées parallèlement les unes aux autres.

3. Agencement selon la revendication 1 ou 2,
**caractérisé en ce que**
au moins certaines des ailettes (15, 16, 17) présentent des alésages (15b) permettant un vissage avec la platine LED (50).

4. Agencement selon l'une quelconque des revendications précédentes,
**caractérisé en ce que**
l'enveloppe externe du corps de refroidissement (10) est complètement fermée.

5. Agencement selon l'une quelconque des revendications précédentes,
**caractérisé en ce que**
la zone surfacique fermée (11, 12) présente une courbure.

6. Agencement selon l'une quelconque des revendications précédentes,
**caractérisé en ce que**
l'enveloppe externe du corps de refroidissement (10) est formée par deux surfaces externes s'étendant comme un pignon l'une vers l'autre, qui présentent de préférence une courbure.

7. Agencement selon l'une quelconque des revendications précédentes,
**caractérisé en ce que**
la platine LED (50) présente plusieurs LED (52), l'ensemble des LEDs (52) étant respectivement positionné au-dessus du bord de fermeture (18) d'une ailette (15, 16, 17) du corps de refroidissement (10).

8. Agencement selon l'une quelconque des revendications précédentes,
**caractérisé en ce que**
les LEDs (52) sont agencées avec une répartition sensiblement homogène sur la platine LED (50).

9. Agencement selon l'une quelconque des revendications précédentes,
**caractérisé en ce que**
l'enveloppe externe du corps de refroidissement (10) et la platine LED (50) renferment conjointement un espace interne de corps de refroidissement, à travers lequel les ailettes (15, 16, 17) s'étendent.

10. Luminaire (100), présentant au moins un agencement constitué par un corps de refroidissement (10) et par une platine LED (50) selon l'une quelconque des revendications précédentes.

11. Luminaire selon la revendication 10,
**caractérisé en ce que**
le luminaire (100) présente des ouvertures de passage d'air (125, 126) sur au moins un côté de l'agencement constitué par le corps de refroidissement (10) et par la platine LED (50).

12. Luminaire selon la revendication 11,
**caractérisé en ce que**
des ouvertures de passage d'air (125, 126) sont formées sur les deux côtés de l'agencement constitué par le corps de refroidissement (10) et par la platine LED (50).

13. Luminaire selon l'une quelconque des revendications 10 à 12,
**caractérisé en ce que**
le corps de refroidissement (10) est un élément d'un seul tenant d'une pièce de boîtier.
